# EUROPEAN PATENT APPLICATION

(11) **EP 1 262 991 A2**
(43) Date of publication of application: **04.12.2002**
(21) Application number: 02078371.8
(22) Date of filing: 26.07.1996
(51) Int. Cl.: G11C 8/16

(54) **Multi-port random access memory**

(30) Priority: 27.07.1995 US 1578 P; 30.11.1995 US 565267; 03.08.1995 US 1856 P; 09.05.1996 US 644081
(62) Divisional of application: 96305523.1
(71) Applicant: Nortel Networks Limited, St. Laurent, Quebec H4S 2A9 (CA)
(72) Inventor: Gibson, Garnet Frederic, Nepean, Ontario K2G 5V5 (CA); Wood, Steven William, Kanata, Ontario K2M 1W5 (CA)
(74) Representative: Ertl, Nicholas Justin

(57) **Abstract**

A multi-port RAM (random access memory) including an array of RAM cells. Each RAM cell has a core cell with a single-ended, pseudo-differential write access port and differential, indirect access read ports. The architecture of the features of the multi-port RAM allows direct scaling of the number of write and read access ports to any practical limit with no adverse effects on cell stability margins and therefore data integrity. Also, disclosed is a design detail for an innovative time multiplexed read port architecture implemented as part of a high-speed 9-port time slot interchange random access memory. It provides a practical, high-speed, low-power and area efficient read port structure to allow eight random access reads per clock cycle. Because all timing is internally generated from a single rising clock transition of a system clock signal, no special control or clocking is required externally to the memory.

## Description

### TECHNICAL FIELD

The present invention relates to a multi-port random access memory.

### BACKGROUND ART

Well known RAMs (random access memories) have at least one address port and include storage elements (core cells). In a paper by A.L. Silburt et al entitled "A 180-MHz 0.8-µm BiCMOS Modular Memory Family of DRAM and Multiport SRAM", IEEE Journal of Solid-State Circuits, Vol. 28, No. 3, March 1993, p. 222, at 227 and 228 show various RAM core cells.

It is a problem to develop a practical, high-speed, low-power and area efficient core cell to support multiple ports (e.g., a single high-speed write port and four high-speed read ports).

In a paper by G. Gerosa et al entitled "A 2.2 W, 80 MHz Superscalar RISC Microprocessor", IEEE Journal of Solid-State Circuits, Vol., 29, No. 12, December 1994, p. 1440, at 1447 shows a RAM storage element with single-ended write access structure. The disclosed structure of five ports (one write port and four read ports) includes a plurality of transistor stacks which are connected to respective bit lines. Each transistor stack has top and bottom MOSFETs (metal oxide semiconductor field effect transistors). The drain-source circuits of the top and bottom MOSFETs are series-connected. The gates of the bottom MOSFETs are connected to respective read port lines. The gates of all top MOSFETs are in parallel connected to the core cell. This results in unnecessary loading on the bit line, since the full MOSFET channel capacitance and internal diffusion capacitance of the top MOSFET in the stack is added to the bit line load for every core cell storing data which will set the gate of the top MOSFET "high". This may as much as double the bit line load, resulting in significantly reduced performance. Furthermore, the implementation described in the paper uses only single-ended read access which, for all but the smallest memories, may result in substantially inferior read performance.

United States Patent No. 5,404,455 granted to D.F. Daly et al on April 4, 1995 discloses a TDM (time division multiplexer) scheme for alternating communication between a pair of RAMs. In a paper by C. Ohno entitled "Self-Timed RAM: STRAM", FUJITSU Sci. Tech. J., 24, 4, December 1988, p. 293 shows a self-timed RAM which has synchronous operation and an on-chip write pulse generator.

The problem is to develop a practical, high-speed, low-power and area efficient read port structure to allow multiple (e.g., eight) random access reads per clock cycle. The straight forward implementation of multiple physical ports throughout the memory would be prohibitively complex and inefficient.

In a paper by F.E. Barber et al, "A 2K x 9 Dual Port Memory", ISSCC Dig. Tech. Papers, Feb. 1985, pp. 44-45 and in a paper by F.E. Barber et al, "A 200ns 512x10 DUAL PORT RAM", Proc. Electron. Conf., vol. 36, Oct. 1982, pp. 380-382 disclose a single port RAM with two asynchronous address, data and control interfaces. Timing is controlled by arbitration between address latch enable signals. A memory access from port A is initiated by asserting the address latch enable signal "low" on port A, an access from port B is initiated by asserting the address latch enable signal "low" on port B. If port B attempts to access the memory while port A is actively accessing the memory, then an arbitration circuit will delay the port B access until the port A access is complete. In the RAM, asynchronous enables are used to initiate memory access.

In a paper by T. Matsumura et al, "Pipelined, Time-Sharing Access Technique for a Highly Integrated Multi-Port Memory", Symp. VLSI Circuits Dig. Tech. Papers, June 1990, pp. 107-108 and in a paper by K. Endo et al, "Pipelined, Time-Sharing Access Technique for an Integrated Multiport Memory", IEEE J. Solid-State Circuits, vol. 26, no. 4, pp. 549-554, April 1991 disclose a dual port memory with respect to a common clock (CLK) which is controlled by common write enable (WE) and chip select (CS) inputs. Likewise, ports 2 and 3 are synchronous with respect to a common clock and control inputs. All inputs for ports 0 / 1 are latched on the rising CLK edge of the port 0 / 1 clock input. All inputs for ports 2 / 3 are latched on the rising CLK edge of the port 2 / 3 clock input. Port pairs 0 /1 and 2 / 3 are time-multiplexed by their respective clock inputs. Port 0 access is active when the CLK input for ports 0 / 1 is high, port 1 is active when the same clock input is low. Likewise, port 2 is active when the CLK input for ports 2 / 3 is high and port 3 is active when the same clock input is low. Output data is then re-timed in a pipeline cycle and is presented to the outputs relative to the respective rising clock edge. Described is a synchronous time-shared access technique that is dependent on the clock duty cycle (duration of the clock high period and clock low period) with half of the memory accesses occurring while the clock is high and the other half occurring while the clock is low.

US 5,590,087 discloses a multi-ported memory device. The device operates to overcome memory cell stability problems by unidirectionally isolating memory cells of the device. The device has a single-terminal write access port, and a signal is written to one terminal only of the storage element of each memory cell.

EP 0468453 discloses a multi-port cache memory for exchanging data or instructions with a plurality of arithmetic circuitries independently, according to the load instructions or store instructions provided from a CPU. The multiport cache memory has a differential write access port, wherein opposite signals are provided on a first terminal of the storage element and a second terminal of a storage element on two differential bit lines. The memory is structured such that read and write capability is provided by these differential lines, with the opposite differential write signals being generated by an input/output circuit which is external to the memory cell.

### SUMMARY OF THE INVENTION

It is an object of the present invention to provide an improved multi-port RAM (random access memory).

In accordance with one aspect of the present invention, there is provided a multiport RAM comprising: store means for storing data, the store means including an array of m rows by n columns of RAM cells, with N read ports; and addressing means for generating M address signals of X- and Y-addresses in response to an input clock signal and an input address signal of address information, the M address signals being generated during one clock cycle of the input clock signal and being different in phase from each other, the X- and Y-addresses of each of the M address signals identifying the row and column of the array of the RAM cell, respectively.

In one example of the multi-port RAM, the addressing means comprises clock generating means for generating first and second control clock signals in response to the input clock signal and the RAM comprises address generating means for generating the address signals of the X- and Y-addresses in response to the first and second control clock signals, respectively. For example, the address generating means includes means for converting the address information contained in the input address signal to the X- and Y-addresses in response to the first and second control clock signals, respectively.

The clock generating means may include timing generating means for generating the first and second control clock signals M times during one clock cycle. The timing generating means has first and second generators, the first generator generating the first and second control clock signals and a reset signal, the second generator generating the first and second control clock signals in response to the reset signal, the generation of the first and second control clock signals being different in phase between the first and second generators.

For example, when data is stored in the RAM cell, the row and column of storing data are identified by the X- and Y-addresses, respectively, and when the data stored in the RAM cell is read, the row and column of reading data are identified by the X- and Y-addresses, respectively.

The RAM cell may be a dynamic random access memory cell or a static random access memory cell.

### BRIEF DESCRIPTION OF THE DRAWINGS

An embodiment of the present invention will now be described by way of example with reference to the accompanying drawings in which:
Figure 1 shows the structure of Figures 1A - 1D which illustrate a multi-port RAM (random access memory) according to an embodiment of the present invention;
Figure 1A is a block diagram of an X-address circuit and a row decode circuit which are included in the multi-port RAM;
Figure 1B is a block diagram of a multi-port core cell array which is included in the multi-port RAM;
Figure 1C is a block diagram of a Y-address circuit, a column decode circuit and a clock generator which are included in the multi-port RAM;
Figure 1D is a block diagram of a bit line access circuit and a data output circuit which are included in the multi-port RAM;
Figure 2 is a detailed circuit diagram of a RAM cell included in the multi-port core cell array shown in Figure 1B;
Figure 3 is a detailed diagram of a latch included in the RAM cell shown in Figure 2;
Figure 4 is a detailed block diagram of the clock generator shown in Figure 1C;
Figure 5 is a detailed circuit diagram of the reset generators shown in Figure 4;
Figure 6 is a timing chart which illustrates the operation of the RAM cell shown in Figure 2; and
Figure 7 is a timing chart which illustrates the operation of the multi-port RAM.

### DETAILED DESCRIPTION

### I. Entire Structure of an Embodiment RAM

The entire structure of a multi-port RAM (random access memory) of an embodiment according to the present invention will now be described.

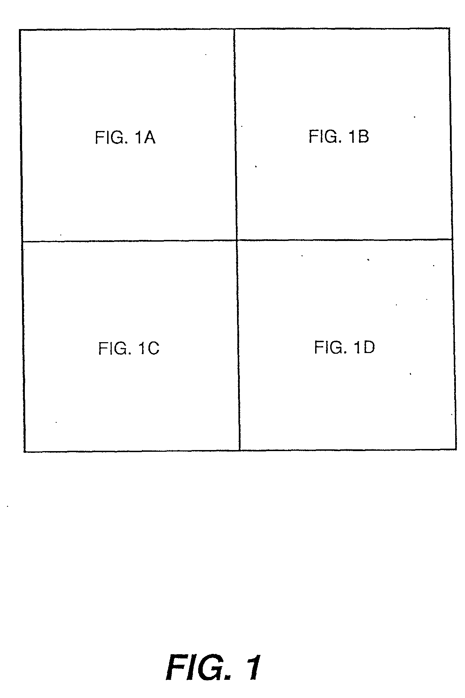

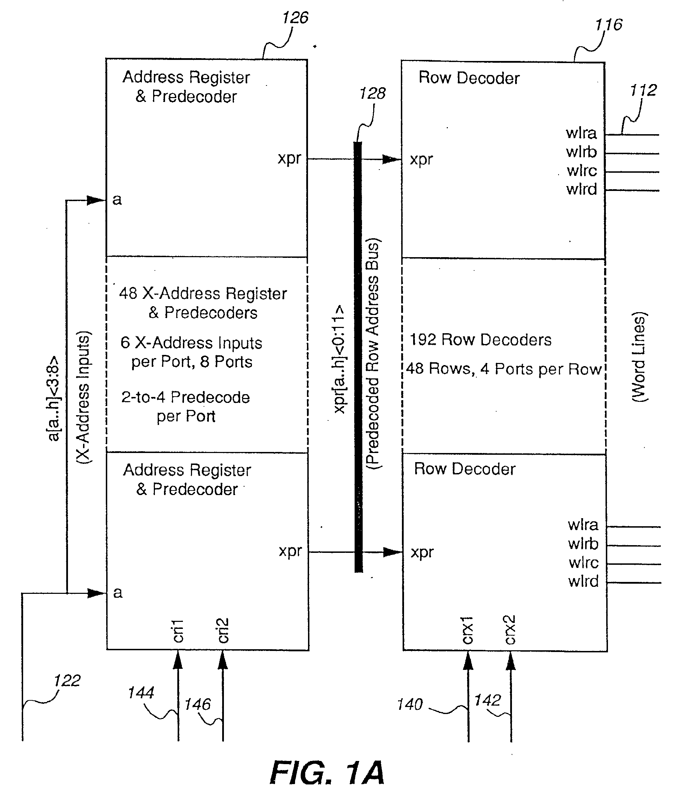

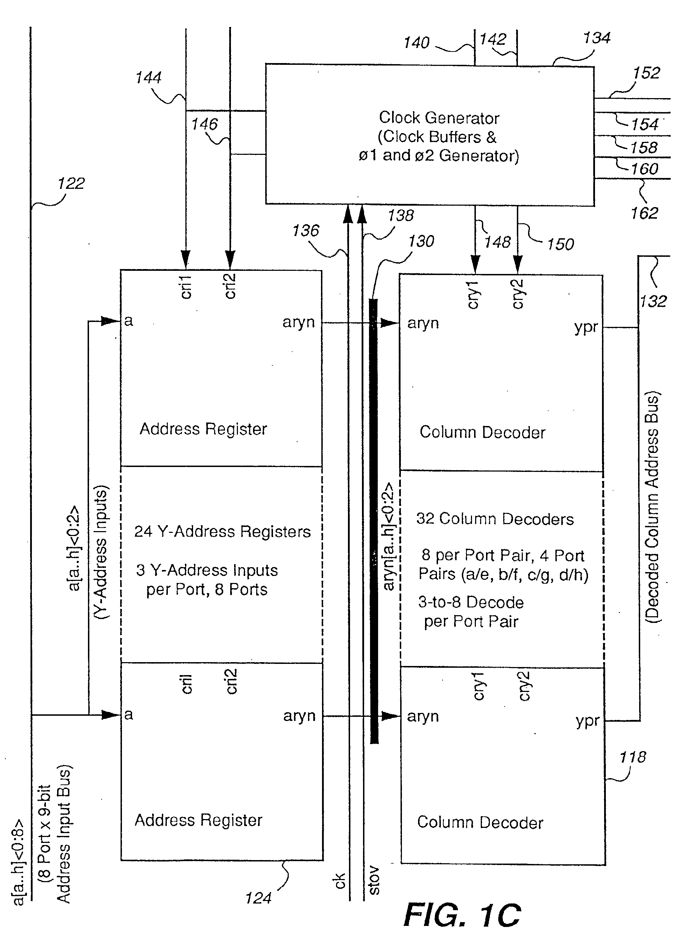

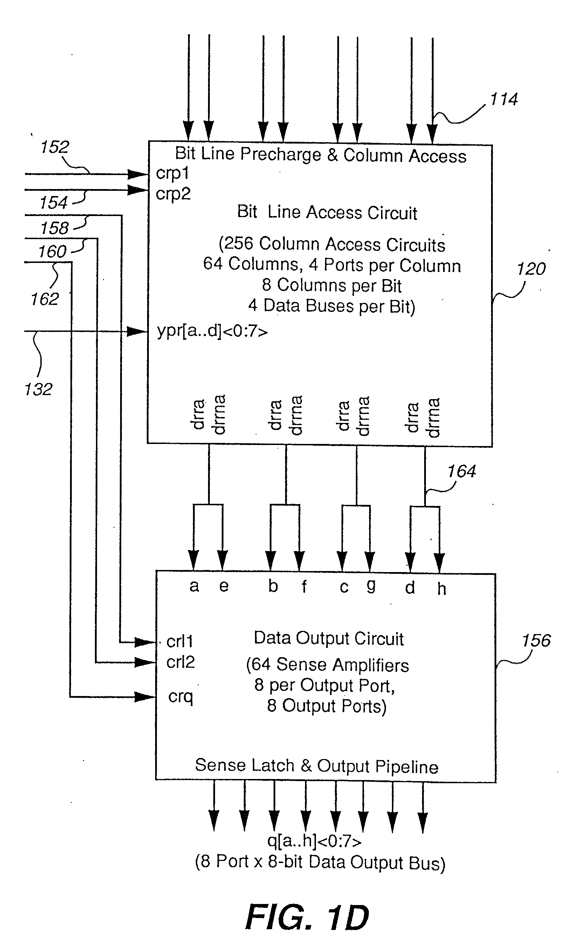

Referring to Figures 1A - 1D, a multi-port RAM has a core cell array 110 of m (=48) rows by n (=64) columns with one write port and four read ports. The core cell array 110 is connected to word lines 112 and bit lines 114. Control circuits for the write port are not shown. Each RAM cell of the core cell array 110 has a dynamic or static storage element. The word lines 112 are connected to the row decode circuit 116. The address identifying the core cell for data reading in the core cell array 110 is determined by X- and Y-address signals which are provided by a row decode circuit 116 and a column decode circuit 118, respectively.

The row decode circuit 116 has 192 row decoders (4 ports per row, 48 rows). The bit lines 114 are connected to a bit line access circuit 120 which has 256 column access circuits (4 ports per column, 64 columns; 8 columns per bit, 4 data buses per bit). The address data is contained in an address signal which is present on an address input bus 122, the address signal having X-and Y-address data. The address input bus 122 is an 8 port x 9-bit address input bus. The 8 ports are represented by "a" - "h". The Y-address data is fed to a Y-address circuit 124 via an 8 port (ports a - h) x 3 bit (bits 0 - 2) bus. The X-address data is fed to an X-address circuit 126 via an 8 port (ports a - h) x 6 bit (bits 3 - 8) bus.

The Y-address circuit 124 has 24 Y-address registers (3 Y-address inputs per port, 8 ports). The X-address circuit 126 has 48 X-address register and predecoders (8 ports, 6 X-address inputs per port; 2-to-4 predecode per port). The X-address circuit 126 is connected to the row decode circuit 116 via a predecoded row address bus 128. The Y-address circuit 124 is connected via a column address bus 130 to the column decode circuit 118 which is connected to the bit line access circuit 120 via a decoded column address bus 132 having decoded Y-address lines. The column decode circuit 118 has 32 column decoders (8 per port pair, 4 port pairs (a/e, b/f, c/g, d/h); 3-to-8 decode per port pair).

Timing of addressing is controlled by a clock generator 134 which is a self-timed, time multiplex control circuit. A clock input line 136 to which a system clock signal ck is fed by a clock source (not shown) is connected to the clock generator 134. Also, a mode line 138 to which a self-timing override mode signal stov is fed by a signal source (not shown) is connected to the clock generator 134. The clock generator 134 generates clock signals of two phases ø1 and ø2 and doubles the frequency of the clock signal by multiplexing. Multiplex control clock signals crx1 and crx2 from the clock generator 134 are fed to the row decode circuit 116 via multiplex clock lines 140 and 142, respectively. Interface clock signals cri1 and cri2 from the clock generator 134 are fed to both the Y-address circuit 124 and the X-address circuit 126 via interface clock lines 144 and 146, respectively. Multiplex control clock signals cry1 and cry2 from the clock generator 134 are fed to the column decode circuit 118 via multiplex clock lines 148 and 150, respectively.

A ø1 precharge clock signal crp1 and a ø2 precharge clock signal crp2 are provided by the clock generator 134 to the bit line access circuit 120 via precharge lines 152 and 154, respectively. A ø1 sense amp latch clock signal crl1, a ø2 sense amp latch clock signal crl2 and an output register clock signal crq are provided by the clock generator 134 to a data output circuit 156 via a sense clock line 158, a sense clock line 160 and a register clock line 162, respectively. The data output circuit 156 has 64 sense amplifiers (8 per output port, 8 output ports,) and is connected to an 8 port x 8-bit data output bus. The data buses 164 from the bit line access circuit 120 are connected to the data output circuit 156.

### II. Detailed Structure of Circuits of the RAM

The following description assumes, for simplicity and purely by way of example, that FETs (field effect transistors) referred to are MOSFETs (metal oxide semiconductor FETs) and a supply voltage +Vcc is +5.0 volts.

### (i) Multi-Port RAM Cell Array

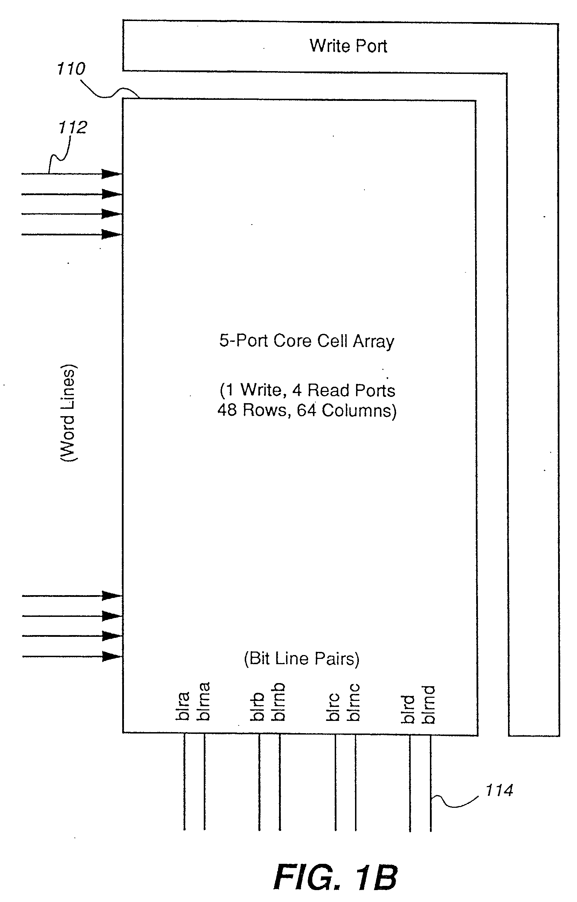

The multi-port RAM cell array shown in Figure 1B will now be described. Each RAM cell of the multi-port RAM cell array consists of four differential read ports with indirect data access via gated, bit line pull-down transistors and one single-ended write-only port with local bit line inversion to give pseudo-differential write access.

Each RAM cell of the multi-port RAM cell array has a five-port storage element (core cell) and includes one write port and four differential read ports with indirect data access. The RAM cell includes a latch 210 which has two inverters 211 and 212. Each of the inverters 211 and 212 has a CMOS (complementary MOS) inverter. The input and the output terminals of the inverter 211 are connected to the output and the input terminals of the inverter 212, respectively.

The source of a FET 214 is connected to the drain of a FET 216 and the source of a FET 218 is connected to the drain of a FET 220. Similarly, the source of a FET 222 is connected to the drain of a FET 224 and the source of a FET 226 is connected to the drain of a FET 228. The source of a FET 230 is connected to the drain of a FET 232 and the source of a FET 234 is connected to the drain of a FET 236. The source of a FET 238 is connected to the drain of a FET 240 and the source of a FET 242 is connected to the drain of a FET 244.

The output terminal of the inverter 211 and the input terminal of the inverter 212 are connected to the gates of the FETs 216, 224, 232 and 240 and the drain of a FET 246. The input terminal of the inverter 211 and the output terminal of the inverter 212 are connected to the gates of the FETs 220, 228, 236 and 244 and the drain of a FET 248 whose source is connected to the drain of a FET 250. The sources of the FETs 216, 220, 224, 228, 232, 236, 240, 244 and 250 are connected to the ground terminal.

The gates of the FETs 246 and 248 are connected to a line 252 on which a write word line signal wlw is present. The gate of the FET 250 and the source of the FET 246 are connected to a line 254 on which a write bit line signal blw representing data "zero" or "one" is present.

A line 256 on which a word line read signal wlra is present is connected to the gates of the FETs 214 and 218. A line 258 on which a word line read signal wlrb is present is connected to the gates of the FETs 222 and 226. A line 260 on which a word line read signal wlrc is present is connected to the gates of the FETs 230 and 234. A line 262 on which a word line read signal wlrd is present is connected to the gates of the FETs 238 and 242.

The drains of the FETs 218, 226, 234 and 242 are connected to bit lines 264, 266, 268 and 270, respectively, on which read bit line signals blra, blrb, blrc and bird are present. The drains of the FETs 214, 222, 230 and 238 are connected to bit lines 272, 274, 276 and 278, respectively, on which read bit line signals blrna, blrnb, blrnc and blrnd are present. The bit lines 264 and 272, 266 and 274, 268 and 276, 270 and 278 are pairs of bit lines and on the respective pairs, the read bit line signals blra and blrna, blrb and blrnb, blrc and blrnc, and blrd and blrnd are which are differential signals are present.

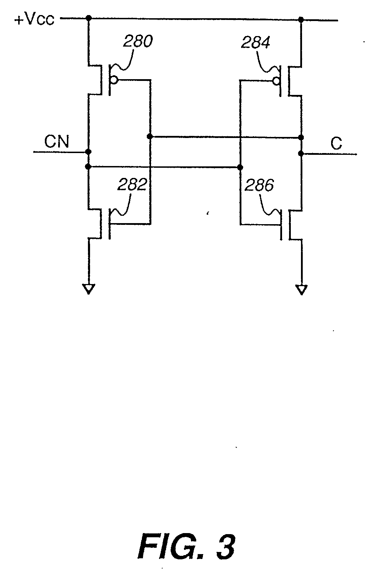

Figure 3 shows a detail of the latch 210 of the multi-port RAM cell array. The latch 210 is a well known RAM storage element which includes two CMOS inverters. In Figure 3, the drains of a P-channel FET 280 (a load device) and an N-channel FET 282 (a drive device), which define one CMOS inverter, are connected to the gates of a P-channel FET 284 (a load device) and an N-channel FET 286 (a drive device), which define the other CMOS inverter. Similarly, the drains of the FETs 284 and 286 are connected to the gates of the FETs 280 and 282. The sources of the FETs 280 and 284 are connected to the voltage terminal of the supply voltage +Vcc. The sources of the FETs 282 and 286 are connected to the ground terminal. The junction of the drains of the FETs 280 and 282 defines node CN. The junction of the drains of the FETs 284 and 286 defines node C. Nodes CN and C are data input and output terminals of the latch 210.

### (ii) Clock Generator

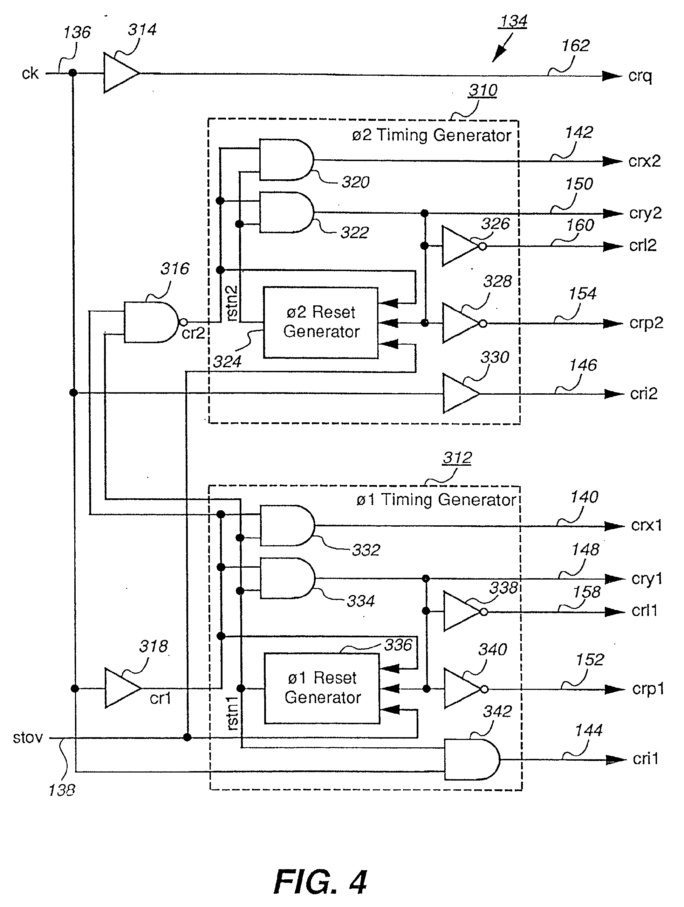

Referring to Figure 4 which shows the clock generator 134 in detail, it has a ø2 timing generator 310, a ø1 timing generator 312, a buffer 314, a NAND gate 316 and a buffer 318. The clock input line 136 to which the system clock signal ck is fed is connected to the ø2 timing generator 310 and the ø1 timing generator 312 and to input terminals of the buffers 314 and 318. The mode line 138 to which the self-timing override mode signal stov is fed is connected to the ø2 timing generator 310 and the ø1 timing generator 312. The buffer 314 delays the system clock signal ck and provides the output register clock signal crq on the register clock line 162. The buffer 318 delays the system clock signal ck and provides a ø1 read clock signal cr1. The output terminal of the buffer 318 is connected to the ø1 timing generator 312 and the NAND gate 316. The ø2 timing generator 310 has two AND gates 320 and 322, a ø2 reset generator 324, two inverters 326 and 328 and a buffer 330.

The ø1 timing generator 312 has two AND gates 332 and 334, a ø1 reset generator 336, two inverters 338 and 340 and an AND gate 342. The clock input line 136 is connected to the buffer 330 and the AND gate 342. The buffer 330 delays the system clock signal ck and provides the interface clock signal cri2 on the interface clock line 146. The output terminal of the buffer 318 is connected to the NAND gate 316, the AND gate 332, the AND gate 334 and the ø1 reset generator 336. The output terminal of the NAND gate 316 is connected to the AND gates 320 and 322 and the ø2 reset generator 324. The output terminal of the AND gate 322 is connected to the ø2 reset generator 324 and the inverters 326 and 328. The output terminal of the AND gate 334 is connected to the ø1 reset generator 336 and the inverters 338 and 340.

The self-timing override mode signal stov is fed to the ø1 and the ø2 reset generators 336 and 324. The override mode signal stov is a diagnostic mode control input signal and it is "high" and "low" in normal and diagnostic modes, respectively.

The ø1 reset generator 336 provides a ø1 reset control signal rstn1 on its output terminal which is connected to the NAND gate 316 and the AND gates 332, 334 and 342. The NAND gate 316 provides a ø2 read clock signal cr2 which is a NAND logic signal of the ø1 read clock signal cr1 and the ø1 reset control signal rstn1. The ø2 reset generator 324 provides a ø2 reset control signal rstn2 on its output terminal which is connected to the AND gates 320 and 322. The AND gate 320 provides the multiplex control clock signal crx2 on the multiplex clock line 142. The multiplex control clock signal crx2 is an AND logic signal of the ø2 read clock signal cr2 and the ø2 reset control signal rstn2. The AND gate 322 provides the multiplex control clock signal cry2 on the multiplex clock line 150. The multiplex control clock signal cry2 is an AND logic signal of the ø2 read clock signal cr2 and the ø2 reset control signal rstn2. The inverter 326 provides the ø2 sense amp latch clock signal crl2 on the sense clock line 160. The ø2 sense amp latch clock signal crl2 is an inverted signal of the multiplex control clock signal cry2. The inverter 328 provides the ø2 precharge clock signal crp2 on the precharge line 154. The ø2 precharge clock signal crp2 is an inverted signal of the multiplex control clock signal cry2. The AND gate 332 provides the multiplex control clock signal crx1 on the multiplex clock line 140. The multiplex control clock signal crx1 is an AND logic signal of the ø1 read clock signal cr1 and the ø1 reset control signal rstn1. The AND gate 334 provides the multiplex control clock signal cry1 on the multiplex clock line 148. The multiplex control clock signal cry1 is an AND logic signal of the ø1 read clock signal cr1 and the ø1 reset control signal rstn1. The inverter 338 provides the ø1 sense amp latch clock signal crl1 on the sense clock line 158. The ø1 sense amp latch clock signal crl1 is an inverted signal of the multiplex control clock signal cry1. The inverter 340 provides the ø1 precharge clock signal crp1 on the precharge line 152. The ø1 precharge clock signal crp1 is an inverted signal of the multiplex control clock signal cry1. The AND gate 342 provides the interface clock signal cri1 on the interface clock line 144. The interface clock signal cri1 is an AND logic signal of the system clock signal ck and the ø1 reset control signal rstn1.

### (iii) Reset Generator

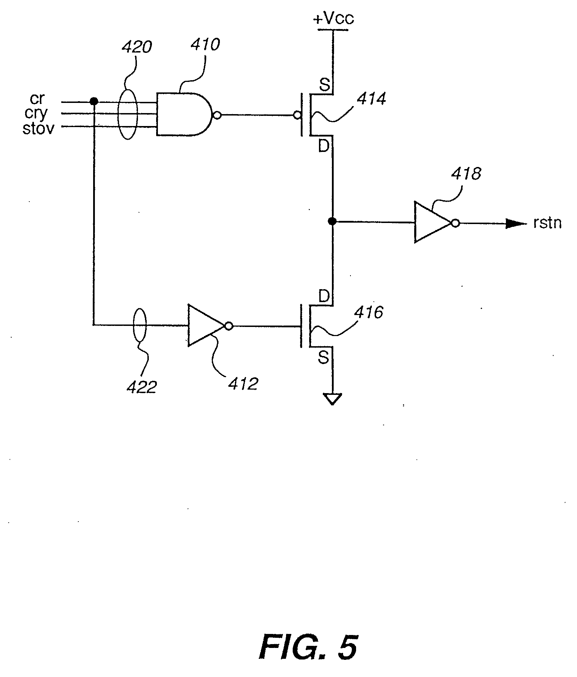

Figure 5 is a detailed circuit diagram of the ø2 reset generator 324 and the ø1 reset generator 336 which have an identical circuit. In Figure 5, each of the generators 324 and 336 is a self-timing reset generator having a NAND gate 410, an inverter 412, a P-channel FET 414, an N-channel FET 416 and an inverter 418. The input terminals of the NAND gate 410 are connected to lines comprised in a set input bus 420 to which the read clock signal cr (the ø1 or ø2 read clock signals cr1 or cr2), the multiplex control clock signal cry (the multiplex control clock signals cry1 or cry2) and the override mode signal stov are provided. The input terminal of the inverter 412 is connected to a reset input line 422 to which the read clock signal cr is provided. The output terminal of the NAND gate 410 is connected to the gate of the P-channel FET 414, the source of which is connected to the voltage supply terminal of a positive voltage +Vcc. The output terminal of the inverter 412 is connected to the gate of the N-channel FET 416, the drain and source of which are connected to the drain of the P-channel FET 414 and the ground terminal, respectively. The drains of the FETs 414 and 416 are connected to an input terminal of the inverter 418 which provides a reset control signal rstn (the ø1 or the ø2 reset control signals rstn1 or rstn2).

### III. Operation of the Embodiment

### (i) Multi-Port RAM

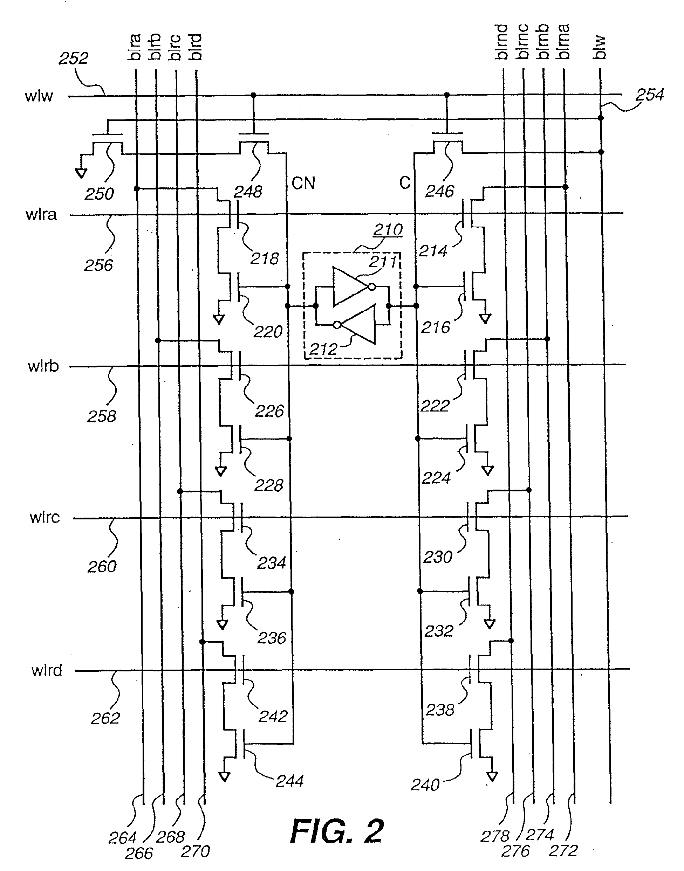

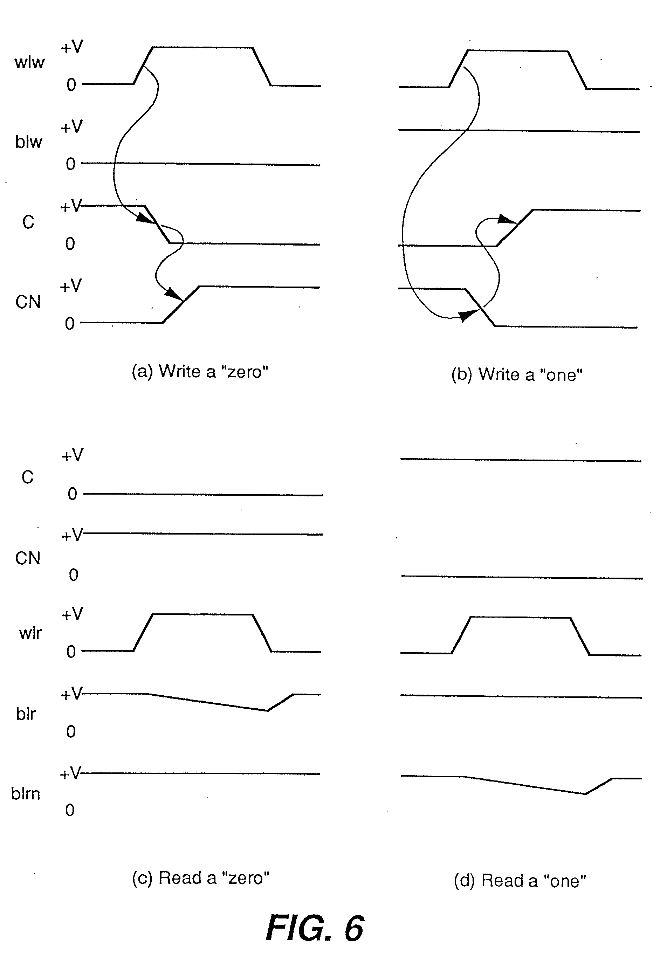

Figure 6 is a timing chart which illustrates the operation of the RAM cell shown in Figure 2. Operation of the multi-port RAM cell array will now be described with reference to Figures 2, 3 and 6.

### Write Mode

The write access port of the embodiment multi-port RAM cell array is single-ended. A single-ended write port is desirable to reduce write power and may eliminate, for example, 50% of the write bit lines from the core array as compared to traditional differential writes.

The FET 246 provides the traditional single-ended N-channel access to node C, resulting in high-speed write access for writing data "zero". The FET 246 is easily margined for high-speed writing against the weak P-channel pull-up FET 284 since it is in common-source mode. However, the FET 246 has insufficient drive to write data "one" into the latch 210 (i.e., node C "high"), since it would be in the source-follower pull-up mode (by the FET 286) where drive capability is significantly reduced. Margining of the N-channel pull-down FET 286 in the latch 210 versus the FET 246 is not feasible for high-speed write access. To achieve the high-speed write to data "one", a pseudo bit line inversion is applied through the FETs 248 and 250 to pull node CN towards ground, when both the write bit line signal blw on the line 254 and the write word line signal wlw on the line 252 are "high". The FET 248 acts as the write access device, while the FET 250 gates the pull-down of node CN, when the write bit line signal blw on the line 254 contains data "one". In spite of the weak P-channel pull-up in the latch 210, since the FETs 248 and 250 connected in series thereto are in common-source mode, the latch 210 write speed is improved.

### (a) Write a "zero" (Figure 6 (a)):

In the embodiment multi-port RAM cell array, when data "zero" or "one" is required to be written into the latch 210, the write word line signal wlw on the line 252 is "high". In a case of data "zero", the write bit line signal blw on the line 254 is "low". In response to "high" at the write word line signal wlw, the FET 246 becomes conductive and node C is pulled-down to "low" through the on FET 246. In response to the pull-down at node C, node CN is pulled-up by the FET 280. Therefore, the FET 286 becomes on, causing node C to maintain "low".

### (b) Write a "one" (Figure 6 (b)):

In a case of data "one", the write bit line signal blw on the line 254 is "high". In response to "high" at the write word line signal wlw and the write bit line signal blw, the FETs 248 and 250 become conductive and node CN is pulled-down towards the ground level ("low"). In response to the pull-down at node CN, node C is pulled-up by the FET 284. Therefore, the FET 282 becomes on, causing node CN to maintain "low".

### Read Mode

The read access port of this embodiment of the multi-port RAM cell array is differential. The indirect read data access scheme consists of the FETs 214, 216, 218 and 220. It supports a large number of parallel read ports without incurring the stability problems of traditional pass-transistor access cells, since there is never any direct access from the read bit lines (on which a differential read bit line signals blr and blrn are present) to the data storage nodes (C and CN). Thus, the cell is inherently stable under all read conditions and need only be margined to meet the write access and soft-error immunity criteria.

### (a) Read a "zero" (Figure 6 (c)):

While the latch 210 stores data "zero", nodes CN and C are "high" and "low", respectively. While the word line read signal wlra on the line 256, for example, is "high", the FETs 218 and 214 are gated. In response to "high" at node CN, the FETs 220 and 218 become on and the bit line 264 is pulled-down by the on FETs 220 and 218, with the result that the read bit line signal blra becomes "low". Because node C is "low", the FETs 216 and 214 are off and the read bit line signal blrna on the line 272 is "high". Hence, by the gating and pull-down functions of the FETs, data "zero" is read.

Similarly, while the word line read signal wlrb on the line 258 is "high", the FETs 226 and 222 are gated. In response to "high" at node CN, the FETs 228 and 226 become conductive and the bit line 266 is pulled-down by the on FETs 228 and 226, with the result that the read bit line signal blrb becomes "low". Because node C is "low", the FETs 224 and 222 are nonconductive and the read bit line signal blrnb on the line 274 is "high". Hence, differential data "zero" is read between the bit lines 266 and 274.

### (b) Read a "one" (Figure 6 (d)):

While the latch 210 stores data "one", nodes CN and C are "low" and "high", respectively. While the word line read signal wlra on the line 256, for example, is "high", the FETs 218 and 220 are gated. In response to "high" at node C, the FETs 216 and 214 become on and the bit line 272 is pulled-down, with the result that the read bit line signal blrna becomes "low". Because node CN is "low", the FETs 220 and 218 are off and the read bit line signal blra on the line 264 is "high". Hence, by the gating and pull-down functions of the FETs, data "one" is read.

Similarly, while the word line read signal wlrb on the line 258 is "high", the FETs 226 and 222 are gated. In response to "high" at node C, the FETs 224 and 222 become conductive and the bit line 274 is pulled-down, with the result that the read bit line signal blrnb becomes "low". Because node CN is "low", the FETs 228 and 226 are nonconductive and the read bit line signal blrb on the line 266 is "high". Hence, differential data "one" is read between the bit lines 274 and 266.

### (ii) Multi-Port RAM

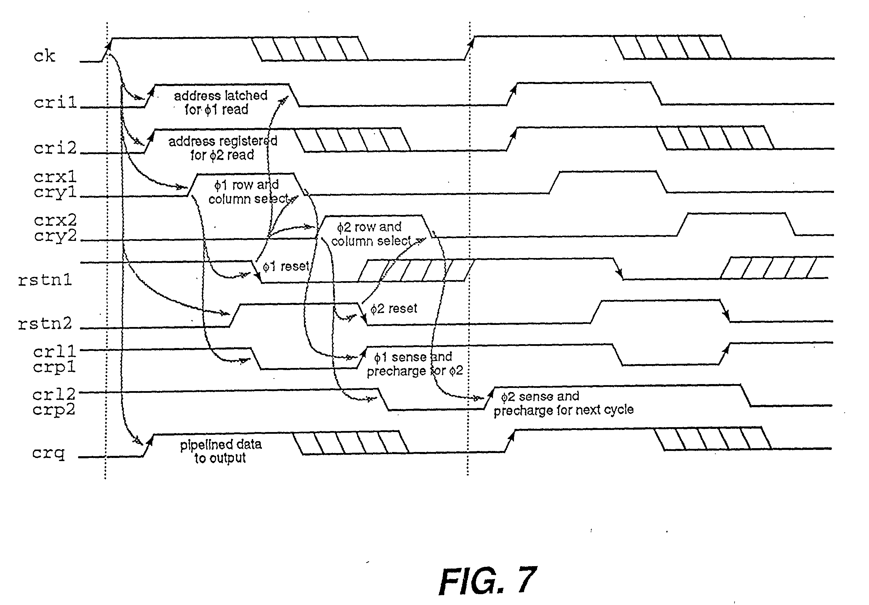

Figure 7 is a timing chart which illustrates the operation of the multi-port RAM. Operation of the embodiment will now be described with reference to the drawings.

### Read Port Access

Time multiplexing is employed in order to create eight data accesses from the four physical read ports in the RAM cell array 110. Every read cycle is divided into two phases: phase 1 (ø1) and phase 2 (ø2). Phase 1 (ø1) accesses provide data for four ports a - d. Phase 2 (ø2) accesses provide data for four ports e - h. The multiplexed read architecture can be seen clearly through the convergence of the port address signal paths on the core, and the divergence of the four data paths in the sense amplifier and output stages.

The eight read ports are fully synchronous with respect to the single clock of the system clock signal ck which is present on the clock input line 136. An internal self-timing mechanism is employed to generate the time multiplex control signals with minimum average power dissipation, regardless of the read clock frequency, duty-cycle, process or operating conditions.

The self-timed, time multiplex control signal timing sequence is shown in Figure 7. Operation of a complete cycle is described below with all steps associated with the time division multiplex read port function.

The rising edge of the system clock signal ck triggers the output register clock signal crq. In response to the output register clock signal crq which is provided in the register clock line 162, the read data path output from the previous cycle is registered in the data output circuit 156. The rising edge of the system clock signal ck initiates the two interface clock signals cri1 and cri2 to latch the eight port address inputs. The interface clock signal cri1 is provided by the ø1 timing generator 312 to the X-address circuit 126 and the Y-address circuit 124 via the interface clock line 144. The interface clock signal cri2 is provided by the ø2 timing generator 310 to the X-address circuit 126 and the Y-address circuit 124 via the interface clock line 146.

The rising edge of the system clock signal ck initiates the multiplex control clock signals crx1 and cry1, which are provided by the ø1 timing generator 312 to the row decode circuit 116 and the column decode circuit 118 via the multiplex clock lines 140 and 148, respectively. In response to the multiplex control clock signal crx1, the ø1 X-addresses (wlr) are selected by the row decode circuit 116. The selected ø1 X-addresses are provided to the word lines 112. Similarly, in response to the multiplex control clock signal cry1, the ø1 Y-addresses (ypr) are selected by the column decode circuit 118. The selected ø1 Y-addresses are provided to the decoded column address bus 132. This accomplishes the ø1 row and column select function. The rising edge of the system clock signal ck sets the ø2 reset control signal rstn2, thereby arming the ø2 clock generation circuitry for subsequent generation of the ø1 reset.

The rising edge of the multiplex control clock signal cry1 triggers the ø1 sense amp latch clock signal crl1 to provide equalization and data access and to re-time ø1 and ø2 data from the previous cycle. The internal self-timing loop feedback path then causes a falling edge on the ø1 reset control signal rstn1. The falling edge of the ø1 reset control signal rstn1 resets the multiplex control clock signals crx1 and cry1. In response to the reset, the port a-d predecoded address lines are reconnected to the address input path and the ø1 row and column addresses are deselected from the word lines 112 and the decoded Y-address lines of the decoded column address bus 132.

The falling edge of the multiplex control clock signal cry1 resets the ø1 sense amp latch clock signal crl1 to initiate latching and the ø1 precharge clock signal crp1 to equalize the data bus and bit lines for the subsequent ø2 read.

The falling edge of the ø1 reset control signal rstn1 initiates the ø2 cycle by enabling the armed multiplex control clock signals crx2 and cry2. The rising edges of the multiplex control clock signal crx2 and the multiplex control clock signal cry2 gate the ø2 X-addresses to the word lines 112 and the ø2 Y-addresses to the decoded Y-address lines. This accomplishes the ø2 row and column select function. The rising edge of the multiplex control clock signal cry2 triggers the ø2 sense amp latch clock signal crl2 to provide equalization and data access. The internal self-timing loop feedback path then causes a falling edge on the ø2 reset control signal rstn2.

The falling edge of the ø2 reset control signal rstn2 resets the multiplex control clock signals crx2 and cry2. In response to the reset, the port e-h predecoded address lines are reconnected to the address input path and the ø2 row and column addresses are deselected from the word lines 112 and decoded Y-address lines. The falling edge of the multiplex control clock signal cry2 resets the ø2 sense amp latch clock signal crl2 to initiate latching and the ø2 precharge clock signal crp2 to equalize the data bus and bit lines for the subsequent ø1 read. The falling edge of the system clock signal ck resets the ø1 reset control signal rstn1, thereby re-arming the ø1 clock generation circuitry for subsequent generation of the next rising clock cycle.

In response to the X- and Y-addresses, the data stored in the cell in the row and column is read. For example, while the word line read signal wlra on the line 256 is "high", the FETs 218 and 214 are gated. A "zero" or "one" data stored in the latch 210 is read through the FETs 220, 218 and 216, 214 between the read bit lines 264 and 272.

### Self-timed, Time Multiplex Control

Self-timed, time multiplex control signals are provided by the clock generator 134 which is shown in detail in Figure 4. In the clock generator 134, there are two self-timing loops controlling the time multiplexed operations. The first loop, which is for the ø1 timing generation and reset and includes the signal paths of the ø1 read clock signal cr1, the multiplex control clock signal cry1 and the ø1 reset control signal rstn1 (a ø1 self-timing loop), includes the path of the AND gate 334 → the ø1 reset generator 336. The second loop, whose operation is triggered by the first through the NAND gate 316, is for the ø2 timing generation and reset. The second loop includes the paths of the ø2 read clock signal cr2, the multiplex control clock signal cry2 and the ø2 reset control signal rstn2 and the path of the AND gate 322 → the ø2 reset generator 324.

Operation of the timing loop is as follows. It is assumed that the system clock signal ck is "low". A new cycle is about to be initiated and the override mode signal stov is "high". In this case, the ø1 read clock signal cr1 is "low" and the ø2 read clock signal cr2 is "high". This causes the ø2 reset control signal rstn2 to be "low" and the ø1 reset control signal rstn1 to be "high". The "high" level on the ø1 reset control signal rstn1 arms the AND gates 332 and 334 which are in the ø1 clock paths. The "low" level on the ø2 reset control signal rstn2 disarms the AND gates 320 and 322 and the ø2 clock paths. The multi-port RAM is now in a "ready state" for the cycle to begin.

On the rising edge of the system clock signal ck, the interface clock signals cri1 and cri2 fire to latch the interface data in the address registers and sequence the ø1 interface operation. The multiplex control clock signals crx1 and cry1, the ø1 sense amp latch clock signal crl1 and the ø1 precharge clock signal crp1 all fire to sequence the x-decode, the y-decode and the data path operation. The ø1 self-timing loop is also triggered and the rising edge of the multiplex control clock signal cry1 feeds back through the ø1 reset generator 336, forcing the ø1 reset control signal rstn1 "low". The falling edge of the ø1 reset control signal rstn1 shuts down all ø1 clocks ending the ø1 cycle. The ø1 reset generator has a tuned delay which allows all ø1 operations to complete before shut down.

The rising edge of the system clock signal ck also causes the ø2 read clock signal cr2 to fall, since the ø1 reset control signal rstn1 is "high". The falling edge of the ø2 read clock signal cr2 will cause the ø2 reset generator 324 to be cleared and the ø2 reset control signal rstn2 will go "high", arming the ø2 clock path.

The falling edge of the ø1 reset control signal rstn1 is used as the trigger to start the ø2 timing generator 310 via the NAND gate 316. The falling edge of the ø1 reset control signal rstn1 causes the ø2 read clock signal cr2 to rise. It causes all ø2 clocks, the multiplex control clock signals crx2 and cry2, the ø2 sense amp latch clock signal crl2 and the ø2 precharge clock signal crp2 to transit their state. As with ø1, the rising edge of the multiplex control clock signal cry2 feeds back through the ø2 reset generator 324, forcing the ø2 reset control signal rstn2 "low". The falling edge of the ø2 reset control signal rstn2 shuts down all ø2 clocks ending the ø2 cycle.

Additional multiplex phases may be added following the ø2 circuitry with the ø2 read clock signal cr2 and the ø2 reset control signal rstn2 feeding the ø3 timing generator, etc.

The falling edge of the system clock signal ck will once again force the ø1 reset control signal rstn1 "high" in preparation for the next cycle. It should be noted that the minimum system clock signal ck "high" period is limited by the length of the ø1 cycle. That is, the system clock signal ck should not be taken "low", before the ø1 reset control signal rstn1 goes "low" or the ø1 cycle may be corrupted.

### Self-Timing Override

A self-timing override mode is provided for the two phase version of the control circuit. By asserting the override mode signal stov "low", the reset circuit operation is disabled and the ø1 and the ø2 reset control signals rstn1 and rstn2 are latched in a "high" state. One rising clock edge is required to force the ø2 reset control signal rstn2 "high", once the override mode signal stov is asserted, the ø1 reset control signal rstn1 is set "high" during the system clock signal ck "low" and remains "high" until the override mode signal stov is released.

With both the ø1 and the ø2 reset control signals rstn1 and rstn2 "high", both the ø1 and ø2 clock paths are armed. The ø1 clocks fire on the rising edge of the system clock signal ck and the ø2 clocks fire on the falling edge. This allows the ø1 and the ø2 cycles to be controlled externally by the duty cycle of the clock for test and debug purposes. This function is not scalable to more phases than two in the embodiment, since the clock input has only two phases.

The innovative feature of the multi-port RAM is the self-timed, time multiplexed read port control which allows the eight read ports to be implemented as four physical port structures accessed twice per clock cycle. No special control or clocking is required externally to the memory since all timing is internally generated from the single rising clock transition. In the multi-port RAM, all ports are fully synchronous with respect to a single clock input. No arbitration between ports is required, since the timing generator has a fixed sequence. The clock must only be "high" or "low" for minimum periods set by the control circuit. The actual timing of the memory operation is generated by the self-timed control circuitry which only requires the rising clock edge as a trigger. Once initiated, the self-timed circuitry completes the M accesses as quickly as possible (in sequence) and then disables the memory in preparation for the next cycle. This technique has two major advantages: 1) the architecture is scalable to many self-timed access phases (M > 2) and 2) the memory shut-down at faster process conditions significantly reduces power consumption, since the circuit is only active for as long as needed to complete the function.

Advantageously, the multi-port RAM is scalable. Although it has been implemented for an eight port function where four physical ports are time multiplexed to give an eight port function there is no reason, for example, that a three port function could not be realized from one physical port if three cycles of multiplexing were used. Any number of timing phases may be added in sequence.

The row and column identification implemented into the read-port may be applied to the control circuits for the write port also. In such a write-port implementation, the address identifying the core cell for data storing in the core cell array 110 is determined by X- and Y-address signals which are provided by the row decode circuit 116 and the column decode circuit 118, respectively. Furthermore, the row and column identification may be implemented into both the read-port and the write-port and the core cells for data storing and reading in the core cell array 110 are determined by X- and Y-address signals.

Although particular embodiments of the present invention have been described in detail, it should be appreciated that numerous variations, modifications, and adaptations may be made without departing from the scope of the present invention as defined in the claims. For example, the data storage element may include various dynamic and static RAM core cells.

## Claims

1. A multi-port RAM comprising:
store means for storing data, the store means including an array of m rows by n columns of RAM cells, with N read ports; and
addressing means for generating M address signals of X- and Y-addresses in response to an input clock signal and an input address signal of address information, the M address signals being generated during one clock cycle of the input clock signal and being different in phase from each other, the X- and Y-addresses of each of the M address signals identifying the row and column of the array of the RAM cell, respectively.

2. The multi-port RAM of claim 1, wherein the addressing means comprises clock generating means for generating first and second control clock signals in response to the input clock signal.

3. The multi-port RAM of claim 2, further comprising address generating means for generating the address signals of the X- and Y-addresses in response to the first and second control clock signals, respectively.

4. The multi-port RAM of claim 3, wherein the address generating means includes means for converting the address information contained in the input address signal to the X- and Y-addresses in response to the first and second control clock signals, respectively.

5. The multi-port RAM of claim 1, 2 or 3, wherein the clock generating means includes timing generating means for generating the first and second control clock signals M times during one clock cycle.

6. The multi-port RAM of claim 5, wherein the first and second control clock signals are generated at the same time.

7. The multi-port RAM of claim 5, wherein the timing generating means has M generators for generating the first and second control clock signals.

8. The multi-port RAM of claim 7, wherein each of the M generators generates the first and second control clock signals at the same time, the signal generation by the M generators occurring in different phases during one clock cycle.

9. The multi-port RAM of claim 5, wherein the timing generating means has first and second generators.

10. The multi-port RAM of claim 9, wherein:
the first generator generates the first and second control clock signals and a reset signal; and
the second generator generates the first and second control clock signals in response to the reset signal,
in which the generation of the first and second control clock signals is different in phase between the first and second generators.

11. The multi-port RAM of claim 1, wherein the number M of the address signals is two.

12. The multi-port RAM of claim 11, wherein the number N of the read ports of the cell is four.

13. The multi-port RAM of claim 12, wherein the four read ports are accessed twice per clock cycle.

14. The multi-port RAM of claim 1, wherein data is stored in the RAM cell, the row and column of storing data being identified by the X- and Y-addresses, respectively.

15. The multi-port RAM of claim 1 or 14, wherein the data stored in the RAM cell is read, the row and column of reading data being identified by the X- and Y-addresses, respectively.

16. The multi-port RAM of claim 1, wherein the RAM cell is a dynamic random access memory cell.

17. The multi-port RAM of claim 1, wherein the RAM cell is a static random access memory cell.
